# EUROPÄISCHE PATENTSCHRIFT

(11) **EP 1 865 484 B1**
(45) Veröffentlichungstag und Bekanntmachung des Hinweises auf die Patenterteilung: **04.11.2020**
(21) Anmeldenummer: 06011870.0
(22) Anmeldetag: 08.06.2006
(51) Int. Cl.: G09F 13/22, G09F 9/33

(54) **Hinweiszeichenleuchte und Lichtsteuersystem**
Illuminated information sign and light control system
Panneau lumineux à caractère informatif et système de commande de lumières

(43) Veröffentlichungstag der Anmeldung: 12.12.2007
(73) Patentinhaber: Eaton Intelligent Power Limited, Dublin 4 (IE)
(72) Erfinder: Prasuhn, Jürgen, 59494 Soest (DE)
(74) Vertreter: Grünecker Patent- und Rechtsanwälte PartG mbB

(56) Entgegenhaltungen:
- EP-A1- 0 687 019
- EP-A2- 1 195 736
- DE-A1- 10 331 385
- US-A- 5 681 756
- US-A1- 2006 086 020

## Beschreibung

Die Erfindung betrifft eine Hinweiszeichenleuchte, insbesondere Rettungszeichen- oder Sichtsheitsleuchte, mit wenigstens einer Lichtquelle und einer zumindest einem Hinweiszeichen versehenen Trägerplatte.

Solche Leuchten werden beispielsweise zur Kennzeichnung eines Rettungsweges innerhalb eines Gebäudes eingesetzt. Bekannte Hinweiszeichenleuchten weisen eine in der Regel transparente Trägerplatte beispielsweise aus Glas auf. Auf dieser ist ein entsprechendes Hinweiszeichen (Piktogramm) im Siebdruckverfahren, als selbstklebende Folie oder in anderer Form aufgebracht.

Wenigstens eine Lichtquelle ist entsprechend angeordnet, um dieses Piktogramm zu beleuchten. Die erforderlichen lichttechnischen Anforderungen insbesondere für Rettungszeichenleuchten sind durch deutsche und internationale Normen, wie z.B. DIN 4844, ISO 3864 und EN 1838, festgelegt. Sind die Hinweiszeichenleuchten bodennah angebracht, ist zusätzlich als weitere Norm die ISO 16069 relevant.

Durch diese Normen sind bestimmte Anforderungen an die Leuchtdichte, Farbe und die Gleichmäßigkeit der Ausleuchtung einer solchen Hinweiszeichenleuchte vorgegeben. Teilweise müssen aufwändige Maßnahmen zur Lichtlenkung und/oder -verteilung vorgenommen werden, um diese Anforderungen zu erfüllen. Dies gilt beispielsweise für Leuchtstofflampen oder Leuchtdioden als Lichtquellen. Es ist beispielsweise aus der Praxis eine solche Hinweiszeichenleuchte bekannt, bei der besonders geformte glasförmige Trägerplatten mit interner keilförmiger Aussparung und zusätzlichen Reflektoren verwendet werden, um eine entsprechende homogene und normenkonforme Ausleuchtung des Piktogramms bzw. Hinweiszeichen sicherzustellen.

Außerdem hat sich bei den bisherigen Lichtquellen herausgestellt, dass diese einen relativ hohen Energieverbrauch, verschleißbehaftet und damit zum Teil eine relativ geringe Lebensdauer sowie geringe Helligkeit und Kontrast aufweisen.

US 2006/086020 A1 offenbart eine Multimodenanzeigeeinrichtung, die aus einer Anzahl von Schichten besteht. Auf einer Oberfläche einer solchen Schicht oder auch auf mehreren Oberflächen können unterschiedliche Nachrichten vorgesehen sein, die durch entsprechende Beleuchtung dieser Schicht jeweils einzeln dargestellt werden können.

Der Erfindung liegt daher die Aufgabe zu Grunde, eine Hinweiszeichenleuchte der eingangs genannten Art dahingehend zu verbessern, dass diese in einfacher konstruktiver Weise und kostengünstig eine höhere Helligkeit, höheren Kontrast sowie geringe Dicke und geringes Gewicht aufweist.

Diese Aufgabe wird durch eine Hinweiszeichenleuchte mit den Merkmalen des Patentanspruchs 1 gelöst.

Erfindungsgemäß ist die OLED als Flächenelement ausgebildet, dass zumindest einen Teil des entsprechenden Hinweiszeichens bildet. Verschiedene solcher Flächenelemente bilden das gesamte Hinweiszeichen. Generell besteht ebenfalls die Möglichkeit, statt der flächenförmigen OLED auch punktförmige OLED's zu verwenden. Bei solchen punktförmigen OLED's würde eine Bilddarstellung des Flächenelements pixelorientiert erfolgen. Insbesondere bei unterschiedlichen Kombinationen von Flächenelementen zu einem Hinweiszeichen kann es als günstig angesehen werden, wenn jedes Flächenelement separat ansteuerbar ist. Dies ist beispielsweise dann nicht notwendig, wenn in einer OLED-Schicht aus entsprechenden Flächenelementen jeweils ein Piktogramm kombiniert wird, so dass alle Flächenelemente gleichzeitig und insgesamt ansteuerbar ausgebildet sind.

Erfindungsgemäß weist das Hinweiszeichen solche zur Lichtemission anregbaren Flächenelemente auf, welche als organische Leuchtdioden (OLED) ausgebildet sind.

Eine solche OLED zeichnet sich durch geringen Energieverbrauch, eine schnelle Reaktionszeit, eine hohe Helligkeit und hohen Kontrast sowie geringe Dicke und Gewicht aus. Außerdem weist sie gegenüber herkömmlichen Leuchtmitteln wie Glühlampen oder dergleichen eine hohe Lebensdauer auf.

Bei solchen OLED's besteht außerdem die Möglichkeit, mittels einer geeigneten Ansteuerelektronik OLED's verschiedener Farben anzusteuern. Diese emittieren dann entsprechend zur Ansteuerung Licht der Farben Rot, Grün oder Blau, wobei die verschiedenen Farben miteinander zu anderen Farben kombiniert werden können. Eine zusätzliche Ausleuchtung der Hintergrundbeleuchtung ist bei der OLED-Technologie im Gegensatz zur bekannten LCD-Technologie nicht erforderlich, wodurch Stromverbrauch und Preis einer entsprechenden Hinweiszeichenleuchte vermindert werden. Eine zusätzliche Lichtquelle ist bei der OLED-Technologie im Unterschied zur LCD-Technologie ebenfalls nicht erforderlich.

Es sei aber nochmals darauf hingewiesen, das erfindungsgemäß eine flächenförmige OLED bevorzugt ist, da bei dieser auf die beschriebene, pixelorientierte Ansteuerung und eine entsprechende komplizierte und teuere Ansteuerelektronik verzichtet werden kann.

Die entsprechenden Flächenelemente werden direkt angesteuert und zur Emission von Licht angeregt, sobald eine entsprechende Gleichspannung von z.B. 2 bis 10 V angelegt wird. Beispiele für solche Flächenelemente insbesondere für Rettungszeichen als Hinweiszeichen sind ein Pfeil und ein in Pfeilrichtung laufendes Piktogrammmännchen. Bei Anlegen der entsprechenden Spannung leuchtet das gesamte Flächenelement und bei Trennung der Spannung wird die Lichtemission sofort unterbrochen.

Erfindungsgemäß besteht die Möglichkeit, mehrere Flächenelemente zu einem Hinweiszeichen und/oder zu unterschiedlichen Hinweiszeichen zu kombinieren. Dadurch lassen sich durch entsprechendes Aktivieren und/oder Deaktivieren einzelner Flächenelemente die sicherheitstechnischen Aussagen des Hinweiszeichens bzw. Piktogramm verändern. Eine solche sicherheitstechnische Aussage ist beispielsweise "Fluchtweg nach rechts", "Fluchtweg nach links", "Fluchtweg nach oben" oder "Fluchtweg nach unten". Selbstverständlich sind andere Piktogramme analog aus einem oder mehreren Flächenelementen zusammensetzbar. Natürlich sind andere Piktogramme ebenso realisierbar, die beispielsweise auch Buchstaben, Ziffern oder Wörter enthalten können. Auch hinsichtlich der Farbe eines Piktogramms oder Flächenelements sind viele Variationen selbst innerhalb eines Flächenelements möglich.

Im einfachsten Fall kann das Flächenelement so ausgebildet sein, dass es nur eine Lichtfarbe emittiert. Selbstverständlich besteht ebenfalls die Möglichkeit, durch entsprechende Segmentierung des Flächenelements beispielsweise die Lichtemission und/oder die Lichtfarbe in jedem Segment zu variieren.

Erfindungsgemäß kann es von Vorteil sein, wenn das Flächenelement im nichtangesteuerten Zustand transparent ist. Auf diese Weise können hinter dem Flächenelement angeordnete Piktogramme oder Lichtquellen sichtbar und entsprechend einsetzbar sein.

Die Transparenz eines nichtangesteuerten Flächenelements ist außerdem als vorteilhaft zu betrachten, wenn Flächenelemente in unterschiedlichen OLED-Schichten angeordnet sind. D.h. dass beispielsweise bei fehlender Ansteuerung eines Flächenelements in einer ersten OLED-Schicht das oder die Flächenelemente von anderen oder zumindest einer weiteren OLED-Schicht angesteuert wird und sichtbar ist. Bei einer solchen Anordnung von Flächenelementen in unterschiedlichen OLED-Schichten besteht außerdem die Möglichkeit, Flächenelemente aus den verschiedenen Schichten miteinander zu kombinieren, wodurch nicht nur durch Kombination der unterschiedlichen Lichtfarben eine neue Lichtfarbe, sondern auch andere Hinweiszeichen oder Piktogramme gebildet werden können.

Es besteht dabei ebenfalls die Möglichkeit, dass mehrere Flächenelemente in einer OLED-Schicht angeordnet sind, aus der selektiv nur ein oder mehrere Flächenelemente mit einem oder mehreren Flächenelementen anderer OLED-Schichten kombinierbar sind.

Um allerdings die Hinweiszeichenleuchte hinsichtlich des entsprechenden Hinweiszeichens nicht zu kompliziert aufzubauen, kann es sich als vorteilhaft erweisen, wenn wenigstens ein Hinweiszeichen in einer OLED-Schicht ausgebildet ist, d.h. durch ein oder mehrere Flächenelemente dieser einen OLED-Schicht gebildet ist. Ein anderes Hinweiszeichen kann in einer weiteren OLED-Schicht gebildet sein.

Es besteht die Möglichkeit, die erfindungsgemäße Hinweiszeichenleuchte als einseitige, zweiseitige, dreiseitige, vierseitige oder mehrseitige und auch als runde, ovale oder sonst gekrümmte Hinweiszeichenleuchte auszubilden. Bei einer einseitigen Hinweiszeichenleuchte ist das entsprechende Piktogramm nur von einer Seite der Leuchte erkennbar, während bei einer zweiseitigen Hinweiszeichenleuchte das Piktogramm entweder von beiden Seiten der Leuchte sichtbar ist oder unterschiedliche Piktogramme auf den jeweiligen Seiten der Hinweiszeichenleuchte sichtbar sind. Dies gilt analog für mehrseitige und gekrümmte Leuchten.

Erfindungsgemäß besteht weiterhin die Möglichkeit, Flächenelemente zur Bildung eines Hinweiszeichens fest insbesondere vor Installation der Hinweiszeichenleuchte auszuwählen. Gegenwärtig werden unterschiedliche Piktogramme als Folie, Siebdruck oder Leuchtenvarianten einsetzabhängig geliefert und entsprechend bevorratet. Eine solche Vielzahl von Leuchten lässt sich erfindungsgemäß reduzieren, indem beispielsweise ein bestimmtes Piktogramm durch feste Kombination der entsprechenden Flächenelemente zur Bildung dieses Piktogramms bei der Hinweiszeichenleuchte ausgewählt und die Leuchte dann installiert wird. Die feste Kombination wird durch eine Drahtbrücke, einen Schalter, einen Dip-Switch oder dergleichen realisiert. Dadurch wird der Planungs- und Installationsaufwand wesentlich vereinfacht und eine geringere Anzahl unterschiedlicher Leuchten wird hergestellt oder bevorratet.

Bei einem anderen Einsatz der erfindungsgemäßen Hinweiszeichenleuchte ist es von Vorteil, wenn die Flächenelemente zur Bildung unterschiedlicher Hinweiszeichen mit einer Ansteuereinrichtung verbunden sind. Dies gilt insbesondere dann, wenn die Hinweiszeichenleuchte Teil ein Lichtsteuersystem, wie beispielsweise ein Fluchtweg-Leitsystems ist. Jede der Leuchten kann dann von einer übergeordneten oder in jeder Leuchte integrierten Steuereinrichtung zur Darstellung unterschiedlicher Hinweiszeichen angesteuert werden. Beispielsweise kann eine Auswahl des entsprechenden Hinweiszeichens abhängig von einem Meldestatus eines Brandmeldesystems oder dergleichen erfolgen, um unterschiedliche Fluchtwege anzuzeigen. Dazu ist jede der Steuereinrichtungen mit dem entsprechenden Brandmeldesystem verbunden.

Neben einer oder mehreren OLED-Schichten kann die Hinweiszeichenleuchte eine Ausleucht- oder Hintergrundbeleuchtungseinrichtung aufweisen. Dadurch werden die entsprechenden Hinweiszeichen, die bei Rettungszeichen in der Regel grün sind, aus- oder hinterleuchtet und dadurch gegebenenfalls besser hervorgehoben. Selbstverständlich können die entsprechenden Flächenelemente auch eine andere Lichtfarbe emittieren und aus- oder hinterleuchtet werden. Sind die entsprechenden Flächenelemente nicht angesteuert und transparent, siehe die obigen Ausführungen, ist nur die Ausleucht- oder Hintergrundbeleuchtungseinrichtung mit ihrer entsprechenden Lichtfarbe sichtbar, so dass in diesem Zusammenhang beispielsweise auch die Hinweiszeichenleuchte ohne Verwendung des eigentlichen Piktogramms als Leuchte einsetzbar ist.

Bei einem einfachen Ausführungsbeispiel kann die Ausleucht- oder Hintergrundbeleuchtungseinrichtung als insbesondere weißleuchtende Schicht in OLED-Technologie ausgebildet sein. Diese OLED-Schicht kann zusätzlich zu den anderen OLED-Schichten mit Flächenelementen angeordnet und/oder in den nicht leuchtenden Bereichen der OLED-Schichten mit Flächenelementen eingebettet sein.

In der Regel weist eine entsprechende OLED-Schicht zumindest eine Anoden-, Kathoden- und Emitterschicht auf. Die Anodenschicht ist in der Regel als transparente, aber elektrisch leitende Schicht ausgebildet. Eine solche Schicht ist beispielsweise eine Indium-Zinn-Oxid-Schicht. Es besteht weiterhin die Möglichkeit, dass neben den vorangehend genannten Schichten zwischen jeweils Anode bzw. Kathode und Emitterschicht noch eine entsprechende Löcherleitungschicht bzw. Elektronenleitungsschicht vorhanden ist. Die Emitterschicht enthält ein entsprechendes organisches Material mit Emitter-Molekülen in geringer Konzentration. In diesen Emittermoleküle rekombinieren die beiden Ladungsträger, d.h. Löcher und Elektronen, wodurch sich ein energetisch angeregter Zustand der Emitter-Moleküle ergibt. Die Emitter-Moleküle geben dann Energie als Lichtemission z.B. in blauer, grüner oder roter Farbe ab.

Ein weiterer Vorteil bei solchen OLED-Schichten ist, dass diese sehr dünn und flexibel sind. So besteht auch die Möglichkeit, die Hinweiszeichenleuchte mit gekrümmten Oberflächen auszubilden, wobei diese Oberflächen die entsprechenden Lichtemissionsflächen sind.

Es sei noch darauf hingewiesen, dass die entsprechenden Emitter-Moleküle sowohl rein organisch als auch metall-organisch sein können. In der Regel ist die Lichtausbeute von metall-organischen Emitter-Molekülen noch größer als für rein organische.

In der Regel sind die entsprechenden Materialien einer OLED-Schicht empfindlich gegenüber Feuchtigkeit oder Sauerstoff, so dass zur weiteren Erhöhung der Lebensdauer und Stabilität der Hinweiszeichenleuchte eine Einkapselung der Schicht oder Schichten in wenigstens eine Trägerplatte von Vorteil ist. Eine solche Trägerplatte ist vorzugsweise aus Glas, da dieses eine gute Abschottung gegenüber Wasser, Sauerstoff oder weiteren Umwelteinflüssen ermöglicht. Kunststoff ist ebenfalls möglich, zeigt aber in der Regel eine schlechtere Abschottung.

Die Herstellung der entsprechenden Flächenelemente aus OLED-Schichten ist relativ einfach, da diese durch Siebdruck, Tintenstrahldruck oder auch Rotationsbeschichtung auf dem entsprechenden Trägermaterial aufbringbar sind.

Die Erfindung betrifft außerdem ein Lichtsteuersystem mit wenigstens einer Steuereinrichtung zur Ansteuerung einer Vielzahl von Leuchten, welche mit der Steuereinrichtung über zumindest eine Versorgungsspannungsleistung verbunden sind. Erfindungsgemäß sind zumindest eine Anzahl der Leuchten als Hinweiszeichenleuchten der oben beschriebenen Art ausgebildet. Die übrigen Leuchten können auch bereits bekannte Hinweiszeichenleuchten, Rettungszeichenleuchten oder Sicherheitsleuchten sein.

Dabei besteht ebenfalls die Möglichkeit, dass eine entsprechende Hinweiszeichenleuchte nicht nur eine solche Leuchte im Lichtsteuersystem ersetzt, sondern sie kann auch einen Teil dieser Leuchte bilden. Beispielsweise kann eine Sicherheitsleuchte zur Ausleuchtung innerhalb eines Gebäudes in einem Notfall durch Zuschaltung einer in ihr integrierten Hinweiszeichenleuchte gleichzeitig einen Hinweis auf einen entsprechenden Rettungsweg oder dergleichen geben. Ebenso besteht die Möglichkeit, dass durch fehlende Ansteuerung der entsprechenden Flächenelemente die Hinweiszeichenleuchte nur mit ihrer weißleuchtenden OLED-Schicht angesteuert ist, und so im Wesentlichen als Sicherheitsleuchte zur weißen oder anders farbigen Ausleuchtung dient.

Bei den erfindungsgemäßen Hinweiszeichenleuchten ist insbesondere von Vorteil, wenn diese dynamisch angesteuert werden, um beispielsweise die Leuchten durch die Steuereinrichtung in Abhängigkeit von Umgebungs- und/oder Betriebsbedingungen anzusteuern. Wenn sich diese entsprechenden Bedingungen ändem, kann eine andere Ansteuerung erfolgen, die beispielsweise zu einem Leuchten anderer Flächenelemente und damit anderer Piktogramme führt.

Ein Beispiel für solche Umgebungs- und/oder Betriebsbedingungen sind solche von einem Brandmeldesystem ermittelte, die dann an die Steuereinrichtung übertragen werden. Die entsprechenden Bedingungen werden von der Steuereinrichtung ausgewertet und entsprechend der Auswertung beispielsweise eine Fluchtrichtung innerhalb eines Gebäudes freigegeben oder gesperrt. Dies erfolgt durch entsprechendes Aktivieren und/oder Deaktivieren von Piktogrammen bzw. Flächenelementen der OLED-Schichten. Es besteht ebenfalls die Möglichkeit, dass neben oder anstelle einer solchen zentralen Steuereinrichtung für eine Vielzahl von Leuchten jeder Leuchte eine Steuereinrichtung zugeordnet ist.

Um die entsprechenden Daten zwischen zentraler Steuereinrichtung und jeder Leuchte oder den jeder Leuchte zugeordneten Steuereinrichtungen zu übermitteln oder auch mit dem Brandmeldesystem zu kommunizieren, können die Daten über die Versorgungsspannungsleitung übertragen werden. Es besteht ebenfalls die Möglichkeit, die Versorgungsspannung in bestimmter Weise zur Übermittlung der Daten zu codieren, siehe beispielsweise EP 1 066 690. Weitere Übertragungsmöglichkeiten für solche Daten sind Funk, eine zusätzliche Datenleitung oder dergleichen. Durch die Verwendung von einer jeden Leuchte zugeordneten Steuereinrichtung besteht ebenfalls die Möglichkeit, solche Daten direkt jeder Leuchte zu übermitteln.

Bei Verwendung einer zentralen Steuereinrichtung ist es weiterhin von Vorteil, wenn jeder Leuchte eine Adresse zuordbar ist. Auf diese Weise kann jede Leuchte individuell in einfacher Weise angesprochen und entsprechend angesteuert werden.

Von Vorteil ist zwar eine Hintergrundbeleuchtung mittels einer entsprechenden OLED-Schicht. Es besteht allerdings auch die Möglichkeit, bei einer erfindungsgemäßen Hinweiszeichenleuchte mittels einer Scheibe mit seitlicher Lichteinkopplung oder Hinterleuchtung durch eine oder mehrere Leuchtstofflampen, LED, Kaltkathodenlampen oder eine Elektrolumineszenzfolie eine entsprechende Hintergrundbeleuchtung zu realisieren. Einer solchen Lösung bleibt als Vorteil die Variabilität der verschiedenen Piktogramme. Allerdings erfordert eine solche Hintergrundbeleuchtung mittels seitlicher Lichteinkopplung einen erhöhten konstruktiven Aufwand; um eine möglichst gleichmäßige Ausleuchtung zu realisieren. Ein solcher Aufwand ist bei einer Hintergrundbeleuchtung mit OLED-Schicht nicht notwendig, da die gleichmäßige Ausleuchtung ohne zusätzliche Maßnahmen möglich ist.

Es besteht ebenfalls die Möglichkeit, verschiedene Piktogramme mit nur einer OLED-Schicht zu realisieren. Dabei müssen dann die entsprechenden Flächenelemente nebeneinander angeordnet werden, wodurch eine solche Leuchte in der Regel relativ unförmig und groß wird.

Im Folgenden werden vorteilhafte Ausführungsbeispiele der Erfindung anhand der in der Zeichnung beigefügten Figuren näher erläutert.

Es zeigen:
- Fig. 1: eine Prinzipdarstellung einer Hinweiszeichenleuchte eines ersten erfindungsgemäßen Ausführungsbeispiels mit Schichtaufbau;
- Fig. 2: eine seitliche Ansicht der Hinweiszeichenleuchte 1 nach Fig. 1 mit verschiedenen Flächenelementen bzw. Piktogramm;
- Fig. 3: ein weiteres Ausführungsbeispiel einer erfindungsgemäßen Hinweiszeichenleuchte in zweiseitiger Ausführung;
- Fig. 4: ein Schnitt entlang der Linie IV-IV aus Fig. 3;
- Fig. 5: eine schematische Darstellung eines Lichtsteuersystems mit einer Anzahl von erfindungsgemäßen Hinweiszeichenleuchten, und
- Fig. 6: eine Prinzipdarstellung einer einer Hinweiszeichenleuchte zugeordneten Steuereinrichtung.

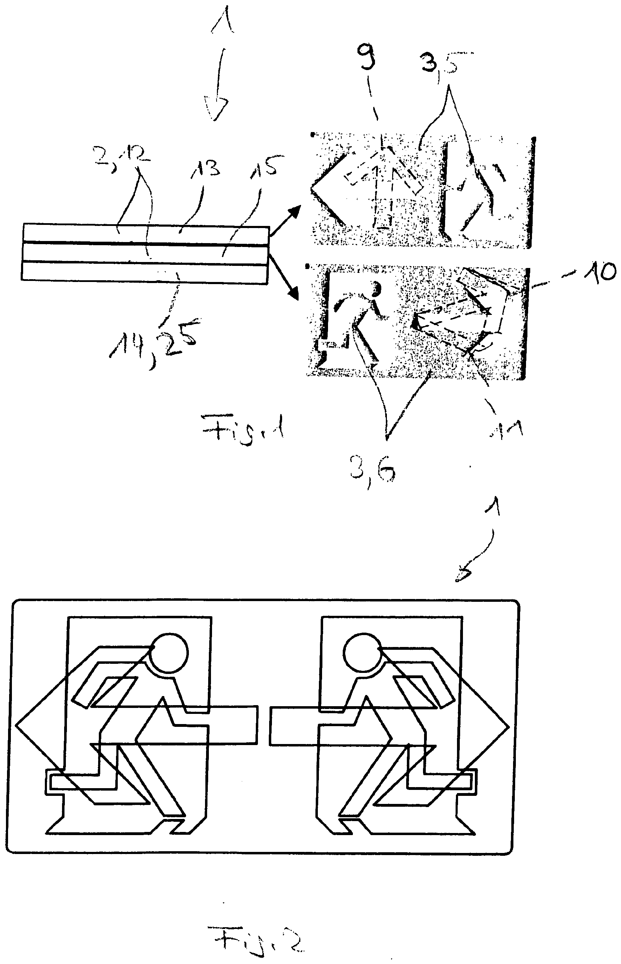

In Fig. 1 ist ein Schichtaufbau aus OLED-Schichten 13 und 15 dargestellt, die direkt nebeneinander und parallel zueinander sowie mit gleichen Abmessungen ausgebildet sind. Jeder der OLED-Schichten weist eine OLED, d.h. organische Leuchtdiode 12 als Lichtquelle 2 auf. Zusätzlich ist eine weitere OLED-Schicht 25 angeordnet, die als Ausleucht-/ Hintergrundbeleuchtungseinrichtung 14 dient.

In der ersten OLED-Schicht 13 ist die OLED als Flächenelement 5 ausgebildet. Dieses Flächenelement weist ein in Fig. 1 nach links laufendes Piktogrammmännchen sowie ein einen nach links weisenden Pfeil umgebende Fläche auf. Dieses Flächenelement 5 bildet ein entsprechendes Hinweiszeichen 3, wie es insbesondere für eine Rettungszeichenleuchte verwendet wird. Generell wird das Flächenelement eine grüne Lichtfarbe aufweisen.

Ist die entsprechende OLED 12 der OLED-Schicht 13 nicht angesteuert, ist das Flächenelement 5 unsichtbar und ein durch die OLED 12 der weiteren OLED-Schicht 15 gebildetes Flächenelement 6 kann angesteuert werden, um entsprechend sichtbar zu sein. Dieses Flächenelement 6 weist ein in Fig. 1 nach rechts laufendes Piktogrammmännchen und ein einen nach rechts weisenden Pfeil umgebende Fläche auf.

Die nicht durch das entsprechend Flächenelement 5 bzw. 6 bedeckten Flächen der Hinweiszeichenleuchte 1 sind bei Ansteuerung der weißleuchtenden OLED-Schicht 25 stärker hervorgehoben, siehe insbesondere die entsprechenden Pfeile in Fig. 1.

Es besteht weiterhin erfindungsgemäß die Möglichkeit, die entsprechenden Hinweiszeichen 3, die durch die Flächenelemente 5 bis 6 gebildet werden, zu variieren. Eine solche Variation kann beispielsweise durch weitere Flächenelemente 9, 10 oder 11 erfolgen. Dabei zeigt die Variation unterschiedliche Pfeilrichtungen. In diesem Zusammenhang kann das entsprechende laufende Piktogrammmännchen mit den weiteren Flächenelementen 9, 10 oder 11 jeweils kombiniert werden, die in unterschiedliche Richtung weisende Pfeile umranden, um so unterschiedliche Fluchtwege nach oben oder unten oder schräg nach oben und schräg nach unten zu kennzeichnen. Die jeweils nach links bzw. nach rechts weisenden Pfeile umrandenden Flächenelemente sind dann nicht angesteuert und transparent.

Dabei besteht weiterhin die Möglichkeit, dass die verschiedenen Flächenelemente 5, 6, 9, 10 und 11 in jeweils unterschiedlichen OLED-Schichten realisiert sind und durch Ansteuerung der OLED 12 in der jeweiligen Schicht aktiviert oder entsprechend deaktiviert werden.

In Fig. 2 ist eine Seitenansicht einer Hinweiszeichenleuchte 1 nach Fig. 1 dargestellt, in der der Überlapp der verschiedenen Flächenelemente 5 und 6 sichtbar ist. Es sei an dieser Stelle nochmals angemerkt, dass bei Aktivierung eines Flächenelements 5 das andere Flächenelement 6 deaktiviert und damit transparent und nicht von außen sichtbar ist. Dies gilt analog für die umgekehrte Aktivierung der Flächenelemente 5 und 6.

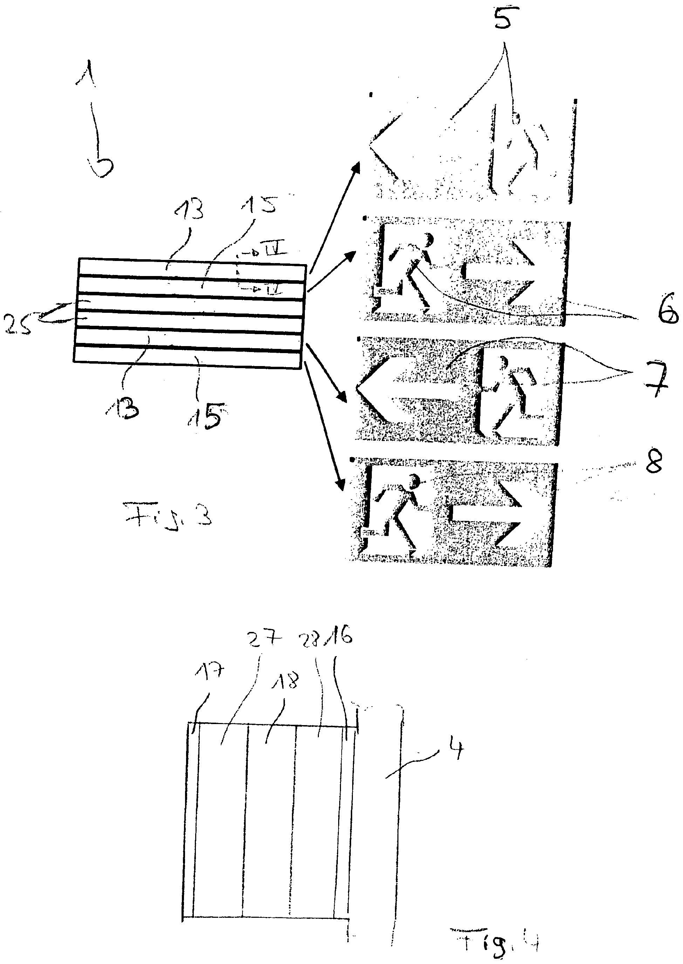

In Fig. 3 ist eine zweiseitige Hinweiszeichenleuchte 1 dargestellt. Diese ist im Wesentlichen durch zusätzliche umgekehrte Anordnung von Schichten einer Hinweiszeichenleuchte 1 nach Fig. 1 auf der Rückseite der Fig. 1 dargestellten Hinweiszeichenleuchte gebildet. D.h., es wird jeweils eine weißleuchtende OLED-Schicht 25 mit zwei OLED-Schichten 13 und 15 mit entsprechendem Flächenelement 5, 6 bzw. 7, 8 verwendet. Auf diese Weise besteht die Möglichkeit, bei einer Betrachtung der Hinweiszeichenleuchte 1 nach Fig. 3 von oben die beiden Flächenelemente 5 bzw. 6 zum Leuchten zu bringen bzw. bei einer Betrachtung in Fig. 3 von unten die Flächenelemente 7 bzw. 8 zum Leuchten zu bringen.

Zur Fig. 3 sei noch angemerkt, dass statt der entsprechenden Flächenelemente 5, 6, 7 oder 8 jeweils einer OLED-Schicht ein entsprechendes Hinweiszeichen oder Piktogramm auch durch Kombination von Flächenelementen unterschiedlicher OLED-Schichten 13, 15 kombinierbar ist, so dass ich eine hohe Variationsanzahl für Piktogramme ergibt. Die entsprechenden weißleuchtenden OLED-Schichten 25 dienen jeweils als Ausleucht- oder Hintergrundbeleuchtungseinrichtung für die jeweilige Seite der Hinweiszeichenleuchte 1.

In Fig. 4 ist ein Schnitt entlang der Linie IV-IV aus Fig. 3 durch eine OLED-Schicht 13 mit entsprechender Trägerplatte 4 dargestellt. Diese ist zur Vereinfachung in den bisherigen Figuren 1 bis 3 nicht dargestellt. Die entsprechende Trägerplatte 4 dient zur Verkapselung der OLED-Schichten 13, 15 und 25.

Jede OLED-Schicht 13, 15, 25 ist zumindest aus einer Anodenschicht 16, einer Kathodenschicht 17 und einer Emitterschicht 18 aufgebaut. In der Regel ist zwischen Anodenschicht 16 und Emitterschicht 18 eine Elektronen-Transportschicht 28 und zwischen

Emitterschicht 18 und Kathodenschicht 17 eine Löcher-Transportsicht 27 angeordnet. In der Emitterschicht 18 rekombinieren die Elektronen und Löcher und erzeugen dadurch einen angeregten Zustand entsprechender Emitter-Moleküle, die in der Emitterschicht 18 enthalten sind. Die Emitter-Moleküle kehren in ihren Grundzustand zurück, wobei die entsprechende Energie als Lichtquanten emittiert werden. Diese Lichtquanten treten durch die transparente Anodenschicht 16 nach außen aus. Die entsprechenden Emitter-Moleküle sind organische oder metall-organische Moleküle. Diese sind durch Siebdruck, Tintenstrahldruck oder Rotationsbeschichtung entsprechend als Flächenelemente aufgebracht.

Die weißleuchtende OLED-Schicht 25 überdeckt in der Regel die gesamte Fläche der entsprechenden Hinweiszeichenleuchte 1 und ist nicht nur in den von den anderen Flächenelementen 5 bis 11 freigelassenen Bereichen, siehe Fig. 3, angeordnet. Dabei erfolgt der Aufbau der entsprechenden weißleuchtenden OLED-Schicht 25 analog zu Fig. 4.

Es sei noch angemerkt, dass bei einer Hinweiszeichenleuchte 1 nach Fig. 1 oder auch nach Fig. 3 bestimmte Flächenelemente 5 bis 11 auch fest auswählbar sind, indem beispielsweise die entsprechende Ansteuerung fest vorgegeben ist durch Verwenden einer Drahtbrücke, eines Schalters oder eines sogenannten Dip-Switches. Dadurch kann während oder auch vor der Installation der Leuchte ein bestimmtes Flächenelement ausgewählt werden, wenn eine Variation des Hinweiszeichens nicht erforderlich ist. In der Regel sind allerdings alle Flächenelemente ansteuerbar, so dass unterschiedliche Hinweiszeichen oder Piktogramme mittels einer Hinweiszeichenleuchte 1 darstellbar sind, um beispielsweise unterschiedliche Fluchtwege bei Rettungszeichenleuchten anzuzeigen.

Die Ansteuerung der Piktogramme kann in diesem Zusammenhang in Abhängigkeit von Umgebungs- oder Betriebsbedingung erfolgen. Die Umgebungsbedingungen können sich beispielsweise im Falle eines Brandes oder dergleichen ändern und einen anderen Fluchtweg erforderlich machen.

Weiterhin sei an dieser Stelle noch angemerkt, dass bei OLED's neben einer flächenförmigen Anordnung als Flächenelement eine im Wesentlichen punktförmige Anordnung möglich ist, so dass die verschiedenen OLED's durch eine pixelorientierten Ansteuerung zur Realisierung unterschiedlicher Hinweiszeichen 3 miteinander kombinierbar sind.

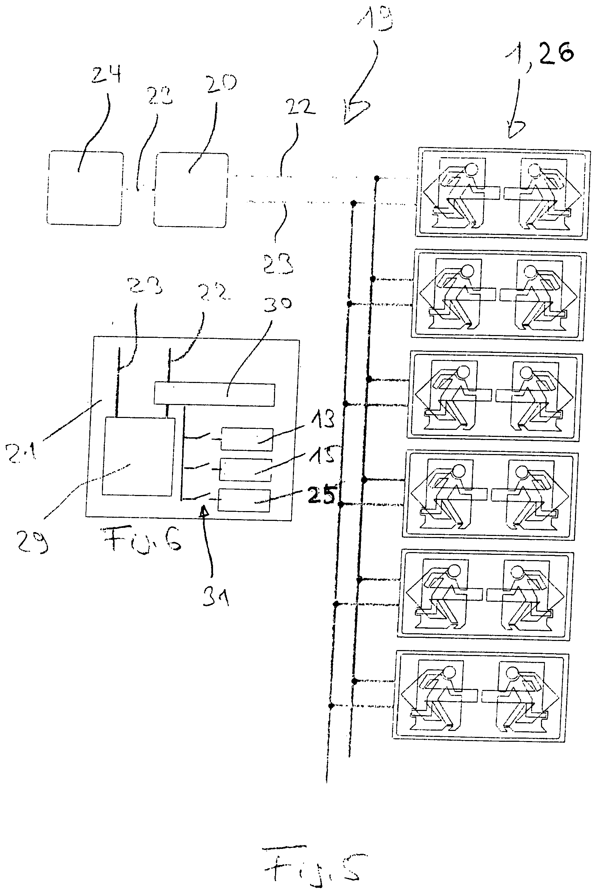

In Fig. 5 ist die Verwendung erfindungsgemäßer Hinweiszeichenleuchten 1 in einem Lichtsteuersystem 19 dargestellt. Dieses weist eine übergeordnete oder zentrale Steuereinrichtung 20 auf, die über eine Datenkommunikationsverbindung 23 mit beispielsweise einem Brandmeldesystem 24 verbunden ist. Informationen des Brandmeldesystems 24 werden als Umgebungs- oder Betriebsbedingungen von der übergeordneten Steuereinrichtung 20 ausgewertet. Entsprechend zu dieser Auswertung erfolgt eine Ansteuerung der Hinweiszeichenleuchten 1 und damit ein Aktivieren und/oder Deaktivieren der entsprechenden Flächenelemente. Die übergeordnete Steuereinrichtung 20 ist mit jeder der Hinweiszeichenleuchten 1 über eine Versorgungsspannungsleitung 22 und gegebenenfalls eine separate Datenkommunikationsverbindung 23 verbunden. Es besteht ebenfalls die Möglichkeit, dass die Kommunikation zwischen Steuereinrichtung 20 und Leuchte 1 über die Versorgungsspannungsleitung 22 beispielsweise durch Überlagern einer Steuerspannung und/oder Codieren der Versorgungsspannung erfolgt. Weiterhin kann die Datenkommunikation auch per Funk oder dergleichen erfolgen. Dies gilt analog für die Datenkommunikationsverbindung 23 zwischen Brandmeldesystem 24 und Steuereinrichtung 20.

Das Lichtsteuersystem 19 kann neben den Hinweiszeichenleuchten 1 noch weitere leuchten 26 aufweisen, wie beispielsweise andere Rettungszeichen- oder Sicherheitsleuchten. Dabei besteht ebenfalls die Möglichkeit, dass diese weiteren Leuchten 26 durch eine Hinweiszeichenleuchte 1 gebildet sind. Beispielsweise kann durch Deaktivieren der Flächenelemente 5 bis 11 nur die entsprechende weißleuchtende OLED-Schicht 25 verwendet werden, wobei die entsprechenden Flächenelemente transparent sind und damit die weißleuchtende Schicht beispielsweise als Sicherheitsleuchte einsetzbar ist.

Ebenso besteht die Möglichkeit, eine erfindungsgemäße Hinweiszeichenleuchte 1 in eine andere Leuchte 26, wie beispielsweise eine Sicherheitsleuchte zu integrieren.

Die entsprechenden Leuchten 1, 26 sind individuell durch die Steuereinrichtung 20 über eine jeder Leuchte zugeordnete Adresse ansteuerbar. Anschließend erfolgt an die entsprechende Ansteuerung der jeweiligen OLED-Schicht, um gegebenenfalls ein erwünschtes Piktogramm zu realisieren

Neben oder auch alternativ zur übergeordneten Steuereinrichtung 20 kann jeder Leuchte 1, 26 eine Leuchtensteuereinrichtung 21 zugeordnet sein. Diese ist in Fig. 6 dargestellt.

Die Leuchtensteuereinrichtung 21 weist in der Regel einen Mikroprozessor 29 auf, der mit der übergeordneten Steuereinrichtung 20 und/oder beispielsweise dem Brandmeldesystem 24 zumindest über die Datenkommunikationsverbindung 23 verbunden ist. Dadurch kann auch direkt von der Leuchtensteuereinrichtung 21 eine Ansteuerung einer jeden Leuchte 1, 26 zur Darstellung eines entsprechenden Hinweiszeichens 2 erfolgen.

Die verschiedenen Schichten 13, 15, 25 einer jeden Leuchte, siehe auch Fig. 1, sind separat mittels einer Schalt- oder Kontakteinrichtung 31 ansteuerbar und mit einer Spannung von der Spannungsversorgungseinrichtung 30 versorgbar.

Der Aufbau der entsprechenden Schichten 13, 15, 25 für die Darstellung des entsprechenden Piktogramms erfolgt dabei analog zu Fig. 4 bzw. zu Fig. 1. In diesem Zusammenhang ist es ebenfalls möglich, dass eine oder mehrere der Leuchten 1 nach Fig. 5 als zweiseitige Leuchte entsprechend zu Fig. 3 ausgebildet sind. Auch diese können über eine entsprechende Leuchtensteuereinrichtung 21 steuerbar sein.

Es sei noch angemerkt, dass es ebenfalls denkbar ist, nur eine weißleuchtende OLED-Schicht zur Hintergrundbeleuchtung im Zusammenhang mit beispielsweise als Folie oder im Siebdruckverfahren aufgebrachtem Piktogramm zu nutzen.

## Patentansprüche

1. Hinweiszeichenleuchte (1), insbesondere Rettungszeichen- oder Sicherheitsleuchte, mit wenigstens einer Lichtquelle (2) und einer mit zumindest einem Hinweiszeichen (3) versehenen Trägerplatte (4), wobei das Hinweiszeichen (3) zur Lichtemission anregbare Flächenelemente (5 bis 11) aufweist, welche als organische Leuchtdioden, OLED, ausgebildet sind, wobei mehrere Flächenelemente (5 bis 11) zu einem Hinweiszeichen (3) und/oder unterschiedlichen Hinweiszeichen kombinierbar sind und die Flächenelemente (5 bis 11) zur Bildung unterschiedlicher Hinweiszeichen (3) mit einer Ansteuereinrichtung (21) verbunden sind **dadurch gekennzeichnet, dass** die Flächenelemente zur Bildung eines Hinweiszeichens (3) fest insbesondere vor einer Installation der Hinweiszeichenleuchte mittels einer Drahtbrücke, eines Schalters, eines Dip-Switches oder dergleichen auswählbar sind.

2. Hinweiszeichenleuchte nach Anspruch 1, **dadurch gekennzeichnet, dass** eine OLED-Schicht zur Hintergrundbeleuchtung des Hinweiszeichens angeordnet ist.

3. Hinweiszeichenleuchte nach Anspruch 1 oder 2, **dadurch gekennzeichnet, dass** das Flächenelement (5 bis 11) nur eine Lichtfarbe emittierend ausgebildet ist.

4. Hinweiszeichenleuchte nach einem der vorangehenden Ansprüche, **dadurch gekennzeichnet, dass** das Flächenelement (5 bis 11) im nichtangesteuerten Zustand transparent ist.

5. Hinweiszeichenleuchte nach einem der vorangehenden Ansprüche, **dadurch gekennzeichnet, dass** Flächenelemente (5 bis 11) in unterschiedlichen OLED-Schichten (13, 15) angeordnet sind.

6. Hinweiszeichenleuchte nach einem der vorangehenden Ansprüche, **dadurch gekennzeichnet, dass** wenigstens ein Hinweiszeichen (3) in einer OLED-Schicht (13, 15) ausgebildet ist.

7. Hinweiszeichenleuchte nach einem der vorangehenden Ansprüche, **dadurch gekennzeichnet, dass** diese als einseitige Hinweiszeichenleuchte ausgebildet ist.

8. Hinweiszeichenleuchte nach einem der vorangehenden Ansprüche, **dadurch gekennzeichnet, dass** diese als mehrseitige, insbesondere zweiseitige Hinweiszeichenleuchte ausgebildet ist.

9. Hinweiszeichenleuchte nach einem der vorangehenden Ansprüche, **dadurch gekennzeichnet, dass** jedes Flächenelement (5 bis 11) separat ansteuerbar ist.

10. Hinweiszeichenleuchte nach einem der vorangehenden Ansprüche, **dadurch gekennzeichnet, dass** diese eine Ausleucht- oder Hintergrundbeleuchtungseinrichtung (14) aufweist.

11. Hinweiszeichenleuchte nach einem der vorangehenden Ansprüche, **dadurch gekennzeichnet, dass** die Ausleucht- oder Hintergrundbeleuchtungseinrichtung (14) als insbesondere weißleuchtende Schicht in OLED-Technologie ausgebildet ist.

12. Hinweiszeichenleuchte nach einem der vorangehenden Ansprüche, **dadurch gekennzeichnet, dass** die insbesondere weißleuchtende OLED-Schicht in wenigstens einem nicht leuchtenden Bereich einer OLED-Schicht mit Flächenelementen eingebettet ist.

13. Hinweiszeichenleuchte nach einem der vorangehenden Ansprüche, **dadurch gekennzeichnet, dass** eine OLED-Schicht zumindest eine Anoden-, eine Kathoden- und eine Emitterschicht aufweist.

14. Hinweiszeichenleuchte nach einem der vorangehenden Ansprüche, **dadurch gekennzeichnet, dass** die OLED-Schicht oder-Schichten (13, 15) in wenigstens einer Trägerplatte eingekapselt sind.

15. Hinweiszeichenleuchte nach einem der vorangehenden Ansprüche, **dadurch gekennzeichnet, dass** die Trägerplatte fest oder flexibel ist.

16. Lichtsteuersystem (19) mit wenigstens einer Steuereinrichtung (20) zur Ansteuerung einer Vielzahl von Leuchten (26) und mit einer Vielzahl von Leuchten (26), welche mit der Steuereinrichtung (20) über zumindest einer Versorgungsspannungsleitung (22) verbunden sind, **dadurch gekennzeichnet, dass** zumindest eine Anzahl der Leuchten (26), als Hinweiszeichenleuchten (1) nach einem der vorangehenden Ansprüche ausgebildet sind oder eine solche enthalten.

17. Lichtsteuersystem nach Anspruch 16, **dadurch gekennzeichnet, dass** Daten zwischen Steuereinrichtung (20) und jeder Leuchte (26) über eine Datenkommunikationsverbindung (23) austauschbar sind.

18. Lichtsteuersystem nach Anspruch 16 oder 17, **dadurch gekennzeichnet, dass** die Leuchte (26, 1) durch die Steuereinrichtung (20, 21) in Abhängigkeit von Umgebungs- und/oder Betriebsbedingungen ansteuerbar ist.

19. Lichtsteuersystem nach einem der vorangehenden Ansprüche 16 und 18, **dadurch gekennzeichnet, dass** Umgebungs- und/oder Betriebsbedingungen von einem Brandmeldesystem ermittel- und an die Steuereinrichtung (20, 21) übertragbar sind.

20. Lichtsteuersystem nach einem der vorangehenden Ansprüche 16 bis 19, **dadurch gekennzeichnet, dass** jeder Leuchte (26, 1) eine Steuereinrichtung (20, 21) zugeordnet ist.

21. Lichtsteuersystem nach einem der vorangehenden Ansprüche 16 bis 20, **dadurch gekennzeichnet, dass** Daten separat zur Versorgungsspannung übertragbar sind.

22. Lichtsteuersystem nach einem der vorangehenden Ansprüche 16 bis 21, **dadurch gekennzeichnet, dass** der Leuchte (26, 1) eine Adresse zuordbar ist.

23. Lichtsteuersystem nach einem der vorangehenden Ansprüche 16 bis 22, **dadurch gekennzeichnet, dass** die Hinweiszeichenleuchte (1) als Sicherheitsleuchte einsetzbar ist.

## Claims

1. An information sign luminaire (1), in particular an escape sign or safety luminaire, including at least one light source (2) and a support plate (4) provided with at least one information sign (3), the information sign (3) having surface elements (5 to 11) excitable to emit light and configured as organic light-emitting diodes, OLEDs, wherein a plurality of surface elements (5 to 11) can be combined to form an information sign (3) and/or different information signs and the surface elements (5 to 11) are connected to a driving device (21) for forming different information signs (3), **characterised in that** the surface elements can be permanently selected to form an information sign (3) by means of a wire bridge, a switch, a dip switch or the like, in particular before installing the information sign luminaire.

2. Information sign luminaire according to claim 1, **characterised in that** an OLED layer is provided for backlighting the information sign.

3. Information sign luminaire according to claim 1 or 2, **characterised in that** the surface element (5 to 11) is configured to emit light of only one color.

4. Information sign luminaire according to any of the preceding claims, **characterised in that** in the non-driven state the surface element (5 to 11) is transparent.

5. Information sign luminaire according to any of the preceding claims, **characterised in that** surface elements (5 to 11) are arranged in different OLED layers (13, 15).

6. Information sign luminaire according to any of the preceding claims, **characterised in that** at least one information sign (3) is formed in an OLED layer (13, 15).

7. Information sign luminaire according to any of the preceding claims, **characterised in that** it is configured as a one-sided information sign luminaire.

8. Information sign luminaire according to any of the preceding claims, **characterised in that** it is configured as a multi-sided, in particular double-sided information sign luminaire.

9. Information sign luminaire according to any of the preceding claims, **characterised in that** each surface element (5 to 11) can be driven separately.

10. Information sign luminaire according to any of the preceding claims, **characterised in that** it includes an illumination or backlighting device (14).

11. Information sign luminaire according to any of the preceding claims, **characterised in that** the illuminating or backlighting device (14) is configured as an OLED layer emitting white light.

12. Information sign luminaire according to any of the preceding claims, **characterised in that** in particular the OLED layer that emitting white light is embedded in a non-luminous region of an OLED layer having surface elements.

13. Information sign luminaire according to any of the preceding claims, **characterised in that** an OLED layer includes at least an anode layer, a cathode layer and an emitter layer.

14. Information sign luminaire according to any of the preceding claims, **characterised in that** the OLED layer or layers (13, 15) is/are encapsulated in at least one support plate.

15. Information sign luminaire according to any of the preceding claims, **characterised in that** the support plate is rigid or flexible.

16. Lighting control system (19) including at least one controller (20) for driving a plurality of luminaires (26) and a plurality of luminaires (26) which are connected to the controller (20) via at least one supply voltage line (22), **characterised in that** at least some of the luminaires (26) are configured as or include information sign luminaires (1) according to one of the preceding claims.

17. Lighting control system according to claim 16, **characterised in that** data can be exchanged between the controller (20) and each luminaire (26) via a data communication link (23).

18. Lighting control system according to claim 16 or 17, **characterised in that** the luminaire (26, 1) can be driven by the controller (20, 21) according to environmental and/or operating conditions.

19. Lighting control system according to one of the preceding claims 16 and 18, **characterised in that** environmental and/or operating conditions can be acquired by a fire alarm system and transmitted to the controller (20, 21).

20. Lighting control system according to one of the preceding claims 16 to 19, **characterised in that** a controller (20, 21) is allocated each luminaire (26, 1).

21. Lighting control system according to one of the preceding claims 16 to 20, **characterised in that** data can be transmitted independent from the supply voltage.

22. Lighting control system according to one of the preceding claims 16 to 21, **characterised in that** an address can be assigned to the luminaire (26, 1).

23. Lighting control system according to one of the preceding claims 16 to 22, **characterised in that** the information sign luminaire (1) can be adopted as a safety luminaire.

## Revendications

1. Panneau lumineux à caractère informatif (1), en particulier panneau lumineux à pictogramme ou panneau lumineux de sécurité, comportant au moins une source lumineuse (2) et une plaque de support (4) munie d'au moins un panneau d'information (3), le panneau d'information (3) présentant des éléments de surface (5 à 11) pouvant être excités pour émettre de la lumière et qui sont conçus comme des diodes électroluminescentes organiques, OLED, dans lequel plusieurs éléments de surface (5 à 11) peuvent être combinés pour former un signe (3) et/ou différents signes et les éléments de surface (5 à 11) sont reliés à un dispositif de commande (21) pour former différents signes (3), **caractérisé en ce que** les éléments de surface peuvent être sélectionnés de manière permanente pour former un signe (3), en particulier avant l'installation du panneau lumineux à caractère informatif, au moyen d'un pont de fils, d'un interrupteur, d'un dip-switch ou similaire.

2. Panneau lumineux à caractère informatif selon la revendication 1, **caractérisé en ce qu'**une couche OLED est disposée pour le rétro-éclairage du panneau d'information.

3. Panneau lumineux à caractère informatif selon les revendications 1 ou 2, **caractérisé en ce que** l'élément de surface (5 à 11) est conçu pour émettre une seule couleur de lumière.

4. Panneau lumineux à caractère informatif selon l'une des revendications précédentes, **caractérisé en ce que** l'élément de surface (5 à 11) est transparent à l'état non activé.

5. Panneau lumineux à caractère informatif selon l'une des revendications précédentes, **caractérisé en ce que les** éléments de surface (5 à 11) sont disposés dans différentes couches OLED (13, 15).

6. Panneau lumineux à caractère informatif selon l'une des revendications précédentes, **caractérisé en ce qu'**au moins un panneau d'information (3) est formé dans une couche OLED (13, 15).

7. Panneau lumineux à caractère informatif selon l'une des revendications précédentes, **caractérisé en ce qu'il est conçu** comme panneau lumineux à caractère informatif à une face.

8. Panneau lumineux à caractère informatif selon l'une des revendications précédentes, **caractérisé en ce qu'il est conçu** comme une lampe pour panneau d'information à plusieurs faces, en particulier à deux faces.

9. Panneau lumineux à caractère informatif selon l'une des revendications précédentes, **caractérisé en ce que** chaque élément de surface (5 à 11) peut être commandé séparément.

10. Panneau lumineux à caractère informatif selon l'une des revendications précédentes, **caractérisé en ce qu'**il comprend un dispositif d'éclairage ou de rétro-éclairage (14).

11. Panneau lumineux à caractère informatif selon l'une des revendications précédentes, **caractérisée en ce que** le dispositif d'éclairage ou de rétro-éclairage (14) est conçu comme une couche en technologie OLED, en particulier une couche lumineuse blanche.

12. Panneau lumineux à caractère informatif selon l'une des revendications précédentes, **caractérisé en ce que** la couche OLED, en particulier la couche OLED blanche, est incorporée dans au moins une région non lumineuse d'une couche OLED avec des éléments de surface.

13. Panneau lumineux à caractère informatif selon l'une des revendications précédentes, **caractérisé en ce qu'**une couche OLED comprend au moins une couche anodique, une couche cathodique et une couche émettrice.

14. Panneau lumineux à caractère informatif selon l'une des revendications précédentes, **caractérisé en ce que** la ou les couches OLED (13, 15) sont encapsulées dans au moins une plaque de support.

15. Panneau lumineux à caractère informatif selon l'une des revendications précédentes, **caractérisé en ce que** la plaque de support est fixe ou flexible.

16. Système de commande de lumières (19) avec au moins un dispositif de commande (20) pour la commande d'une pluralité de panneaux lumineux (26) et avec une pluralité de panneaux lumineux (26) qui sont reliés au dispositif de commande (20) par au moins une ligne de tension d'alimentation (22), **caractérisé en ce qu'**au moins un certain nombre de panneaux lumineux (26) sont conçus comme des panneaux lumineux à caractère informatif (1) selon l'une des revendications précédentes qui contiennent un tel panneaux lumineux.

17. Système de commande de lumières selon la revendication 16, **caractérisé en ce que les** données sont échangeables entre les moyens de commande (20) et chaque panneau lumineux (26) via une liaison de communication de données (23).

18. Système de commande de lumières selon les revendications 16 ou 17, **caractérisé en ce que** le panneau lumineux (26, 1) peut être commandé par le dispositif de commande (20, 21) en fonction des conditions ambiantes et/ou de fonctionnement.

19. Système de commande de lumières selon l'une des revendications précédentes 16 et 18, **caractérisé en ce que** les conditions ambiantes et/ou de fonctionnement peuvent être déterminées par un système d'alarme incendie et transmises au dispositif de commande (20, 21).

20. Système de commande de lumières selon l'une des revendications précédentes 16 à 19, **caractérisé en ce qu'**un dispositif de commande (20, 21) est associé à chaque panneau lumineux (26, 1).

21. Système de commande de lumières selon l'une des revendications précédentes 16 à 20, **caractérisé en ce que** les données peuvent être transmises séparément de la tension d'alimentation.

22. Système de commande de lumières selon l'une des revendications précédentes 16 à 21, **caractérisé en ce qu'**une adresse peut être attribuée au panneau lumineux (26, 1).

23. Système de commande de lumières selon l'une des revendications précédentes 16 à 22, **caractérisé en ce que** la lampe du panneau lumineux à caractère informatif (1) peut être utilisée comme panneau lumineux de sécurité.
